# EUROPÄISCHE PATENTSCHRIFT

(11) **EP 0 968 403 B1**
(45) Veröffentlichungstag und Bekanntmachung des Hinweises auf die Patenterteilung: **21.05.2003**
(21) Anmeldenummer: 98910726.3
(22) Anmeldetag: 05.03.1998
(51) Int. Cl.: G01D 5/14

(54) **BEDIENVORRICHTUNG**
OPERATING DEVICE
DISPOSITIF DE COMMANDE

(30) Priorität: 21.03.1997 DE 19712049
(43) Veröffentlichungstag der Anmeldung: 05.01.2000
(73) Patentinhaber: Siemens Aktiengesellschaft, 80333 München (DE)
(72) Erfinder: BLUME, Jochen, D-64291 Darmstadt (DE); BREINICH, Herbert, D-65205 Wiesbaden (DE); SCHMIDT, Peter, D-61350 Bad Homburg (DE)
(86) Internationale Anmeldenummer: EP9801242
(87) Internationale Veröffentlichungsnummer: WO98043047

(56) Entgegenhaltungen:
- EP-A- 0 677 933
- DE-A- 3 937 149
- PATENT ABSTRACTS OF JAPAN vol. 7, no. 290 (P-245), 24.Dezember 1983 & JP 58 162813 A (TOKYO SHIBAURU DENKI KK), 27.September 1983,

## Beschreibung

Die Erfindung betrifft eine Bedienvorrichtung zur manuellen Eingabe von Informationen in ein Gerät, mit einem Stellglied, dessen Stellung unter Einwirkung einer Betätigungskraft veränderbar ist und das mit einem Wandler zur Erzeugung von elektrischen Signalen verbunden ist, die die Stellung des Stellgliedes kennzeichnen und mit einem mit dem Stellglied verbundenen Motorelement, das unter Steuerung der elektrischen Signale eine Kraft auf das Stellglied ausübt, wobei die Größe und Richtung der Kraft von der Stellung des Stellgliedes und/oder der einzugebenden Information abhängig ist. Aus dem Stand der Technik ist es bekannt, das Stellglied über eine Welle mit einem Wandler in Form eines Inkrementalgebers und über eine weitere Welle mit einem Motor zu verbinden.

Aus JP-A-58 16 28 13 ist ein Positionsdetektor mit einem drehbaren Permanentmagneten und Hallelementen bekannt. Aus der DE 39 37 149 A1 ist ein Kreuzspulmeß- und Anzeigegerät bekannt, bei dem ein Meßwerk eine Kreuzspule mit zwei auf einem Spulenträgerkörper unter praktisch rechtem Winkel zueinander aufgewickelten Spulen bekannt, mit einem innerhalb der Kreuzspule angeordneten Magnerotor mit einer Rotorwelle, wobei der Rotor in Abhängigkeit der Bestromung der Kreuzspule drehbar ist. Aus der EP 677 933 A2 ist eine Eingabeeinheit mit einem Stellglied bekannt, wobei die Stellung des Stellgliedes mittels eines Inkrementalgebers feststellbar ist, und eine Gegenkraft mittels einer elektrischen Bremse auf das Stellglied ausübbar ist.

Nachteilig hierbei ist es, daß diese Bauform wegen des zusätzlichen Inkrementalgebers einen großen Platz- bzw. Raumbedarf aufweist. Aufgabe der Erfindung ist es daher, eine entsprechende Bedienvorrichtung mit haptischer Rückmeldung anzugeben, die nur wenig Platz bzw. Raum erfordert. Diese Aufgabe wird dadurch gelöst, daß der Wandler aus dem Rotor des Motorelementes und Sensoren besteht, die in Abhängigkeit der Stellung des Rotors jeweils ein elektrisches Signal abgeben. Der Rotor des Motorelementes erfüllt also noch die zusätzliche Funktion eines Winkelgebers des Wandlers. Die Erfindung bringt somit den Vorteil, daß für den Wandler nur die zusätzlichen Sensoren erforderlich sind. Ein als diametral magnetisierte Scheibe ausgestalteter Rotor bringt eine einfache und preiswerte Lösung für den Rotor. In Verbindung mit mindestens zwei Hallsensoren läßt sich aus den Spannungen, die das Magnetfeld der diametral magnetisierten Scheibe in den Hallsensoren hervorruft, der genaue

Drehwinkel im Bereich von 360° ermitteln. Hierzu reichen zwei Hallsensoren vollständig aus.

Sofern die beiden Hallsensoren im gleichen radialen Abstand um 90° in Drehrichtung versetzt angeordnet sind, läßt sich die Stellung des Rotors besonders einfach berechnen.

Durch Verwendung eines Kreuzspulenpaars läßt sich das Motorelement sehr kompakt aufbauen. Weiterhin läßt sich durch jeweils unterschiedliche Ansteuerungen der beiden Spulen jede gewünschte Drehmomentcharakteristik bei jedem gewünschten Winkel erreichen. Die Drehmomentcharakteristik und der Winkel sind also durch eine Veränderung der Ansteuerung entsprechend beliebig verstellbar. Die gewünschten Momentenkennlinien sind in einem Speicher abgelegt und aus diesem auslesbar. So können je nach dem, welche Daten eingelesen werden, verschiedene Drehmomente erzeugt werden. So können z.B. bei der Verstellung der Lautstärke durch entsprechenden Momentenverlauf Raststellungen nachgebildet werden, während bei der Verstellung der Lautstärke von einzelnen Lautsprechern eines Gerätes (Balance, Fader) eine geschwindigkeitsproportionale Reibung nachgebildet wird, die der die Bedienvorrichtung benutzenden Person das Gefühl des Verstellens eines Potentiometers vermittelt.

Durch die Verwendung eines Wickelkörpers, auf den die Spulen aufgewickelt sind, läßt sich das Motorelement mit den Spulen einfach und robust herstellen. Dadurch, daß der Wickelkörper den Rotor vollständig einschließt, wird verhindert, daß der Motor verschmutzt.

Durch Verwendung eines Getriebes zwischen dem Motorelement und dem Stellglied läßt sich das auf das Stellglied wirkende Drehmoment erhöhen. Die Ausgestaltung des Stellgliedes als Stellknopf ist gut mit der Hand bedienbar.

Besonders einfach sind die Sensoren zu montieren, wenn sie auf einer Leiterplatte angeordnet sind, die unterhalb der Spule und/oder des Wikkelkörpers montiert ist.

Durch das Umschließen der Unterseite und weitgehend auch der Seiten der Bedienvorrichtung mit einem Rückschlußtopf wird ein zusätzlicher Schutz vor Verunreinigung erreicht. Die Verwendung von weichmagnetischem Material mit einer hohen Hysterese bringt zum Einen eine Abschirmung von Störungen in Form von elektromagnetischen Feldern, die innerhalb der Bedienvorrichtung entstehen und sonst nach außen dringen würden als auch von Feldern, die sonst von außerhalb auf die Bedienvorrichtung einwirken würden. Eine hohe Hysterese vereinfacht durch eine hohe Dämpfung des magnetischen Kreises auch die Regelung. Weiterhin ist ein solches Material wie z.B. St 37 besonders preisgünstig. Zusätzlich hebt ein Rückschlußtopf aus weichmagnetischem Material den Arbeitspunkt des Magneten an und erhöht so dessen Wirkungsgrad.

Die Erfindung wird nachfolgend anhand der Figuren für besonders bevorzugte Ausführungsbeispiele erläutert. Es zeigen:
- Figur 1: den Schnitt durch ein erstes Ausführungsbeispiel,
- Figur 2: den Schnitt A-A aus Figur 1,
- Figur 3: den Schnitt durch ein zweites Ausführungsbeispiel,
- Figur 4: den Schnitt B-B aus Figur 3,
- Figur 5: den Verlauf von Signalen, die zwei Hallsensoren liefern,
- Figur 6: mögliche Drehmomentverläufe, die mit der Bedienvorrichtung erzeugt werden können.

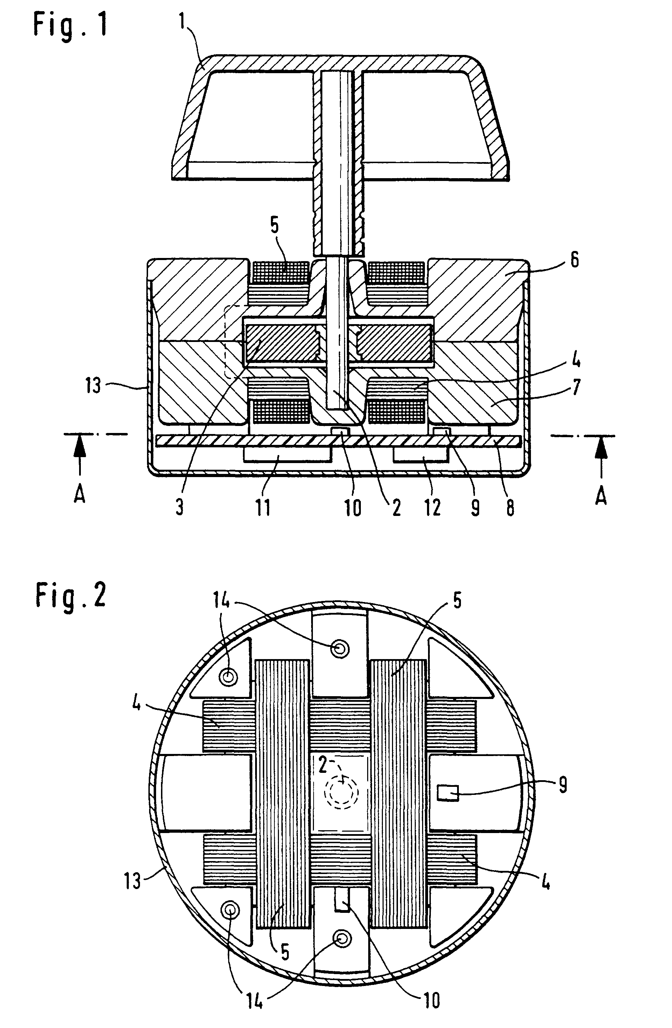

Die Bedienvorrichtung in Figur 1 weist ein Stellglied in Form eines Drehknopfes 1 auf, der über eine Welle 2 mit einem Rotor 3 in Form einer diametral magnetisierten Scheibe verbunden ist. Der Rotor 3 wirkt mit den in den Spulen 4, 5 erzeugten Feldern zusammen und erzeugt so eine Drehbewegung oder ein Drehmoment. Die Spulen 4, 5 sind jeweils in zwei Hälften aufgeteilt und auf einen Wickelkörper, bestehend aus einem Wikkelkörperoberteil 6 und einem Wickelkörperunterteil 7, aufgewickelt. Der Wickelkörper 6, 7 ist so ausgestaltet, daß der Rotor 3 vollständig eingeschlossen ist. Auf einer Leiterplatte 8 sind Hallsensoren 9, 10 derart angebracht, daß sie im gleichen radialen Abstand von der Drehachse des Rotors 3 um 90° versetzt angeordnet sind. Aus den Spannungen, die durch das Magnetfeld des Rotors 3 in den Hallsensoren 9, 10 erzeugt werden, wird in der Auswerteeinrichtung 11 der Drehwinkel des Rotors 3 und damit auch des Drehknopfes 1 berechnet. In der Vorrichtung 12 werden dann die Spannungen erzeugt, die an den Spulen 4, 5 erforderlich sind, um die gewünschten Drehmomente durch das Zusammenwirken des Rotors 3 mit dem Strom durch die Spulen 4, 5 zu erzeugen. Dies geschieht in Abhängigkeit des errechneten Drehwinkels und/oder der anzugebenden Information.

Ein Rückschlußtopf 13 umschließt den Wickelkörper 6, 7 an seiner Unterseite und weitgehend an seinen Seiten. In dem aus der Unterseite des Wickelkörperunterteils 7 und dem Rückschlußtopf 13 gebildeten Raum ist auch die Leiterplatte 8 mit den Hallsensoren 9, 10, der Auswerteeinrichtung 11 und der Vorrichtung 12 untergebracht.

In Figur 2 ist die Lage der Hallsensoren 9, 10 und der Spulen 4, 5 näher dargestellt. Man erkennt, daß die Hallsensoren 9, 10 den gleichen radialen Abstand von der Welle 2 und damit der Drehachse des in Figur 2 nicht dargestellten Rotors 3 aufweisen und daß sie um 90° versetzt angeordnet sind. Die Spulen 4, 5 sind über vier Kontaktstifte 14 und nicht dargestellte Leiterbahnen auf der Leiterplatte 8 mit der Vorrichtung 12 elektrisch verbunden.

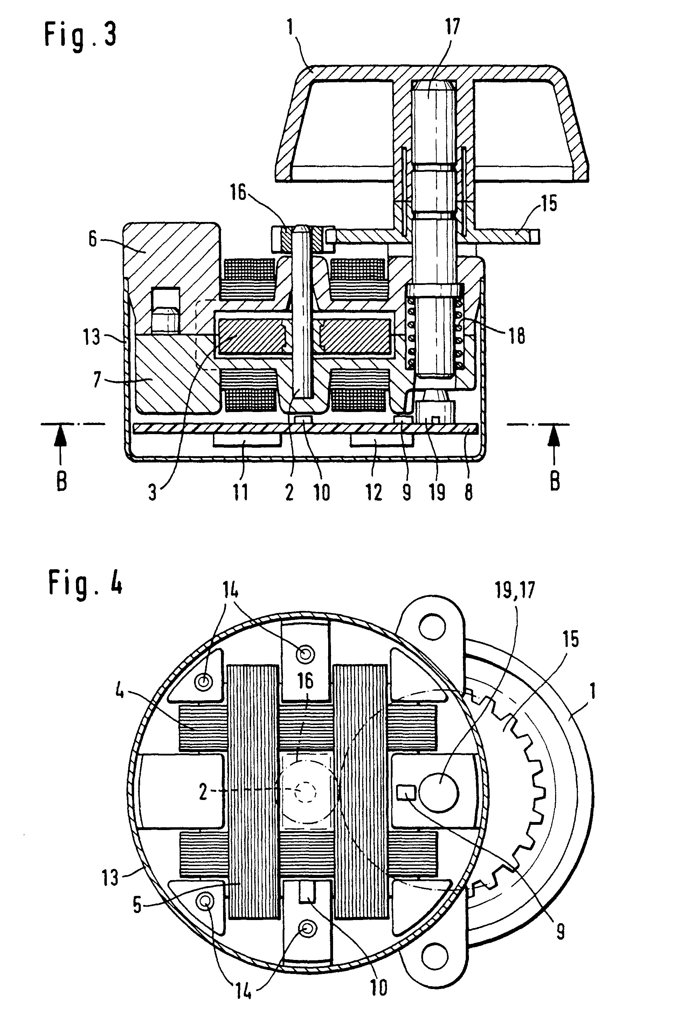

Das in den Figuren 3 und 4 dargestellte Ausführungsbeispiel unterscheidet sich von dem zuvor beschriebenen Ausführungsbeispiel hauptsächlich dadurch, daß der Drehknopf 1 nicht direkt auf der Welle 2, sondern auf einem Stellschaft 17 angeordnet ist, der über ein Getriebe, bestehend aus dem Zahnrad 15 und dem Ritzel 16, mit der Welle 2 verbunden ist, wobei das Ritzel 16 auf der Welle 2 sitzt. Der Stellschaft 17 weist weiterhin die Besonderheit auf, daß er zusammen mit dem Drehknopf 1 in axialer Richtung gegen die Kraft einer Druckfeder 18 bewegbar ist und dadurch ein Taster 19 betätigbar ist. Die übrigen Bauteile stimmen mit den Bauteilen des Ausführungsbeispiels aus den Figuren 1 und 2 überein. Durch das Getriebe, bestehend aus dem Zahnrad 15 und dem Ritzel 16, wird das an dem Drehknopf 1 anliegende Drehmoment erhöht. Durch den Taster 19 kann z.B. ein Menü-Punkt durch Drücken ausgewählt werden, wenn die Bedienvorrichtung die Funktion hat, durch Drehen des Drehknopfes 1 verschiedene Menü-Punkte anzuzeigen und bei einer Aufeinanderfolge von einzelnen Menü-Punkten den angezeigten Menü-Punkt auszuwählen oder bei gleichzeitiger Anzeige mehrerer Menü-Punkte einen hervorgehobenen Menü-Punkt auszuwählen, wobei durch Drehen des Drehknopfes 1 auch andere angezeigte Menü-Punkte nacheinander hervorhebbar sind.

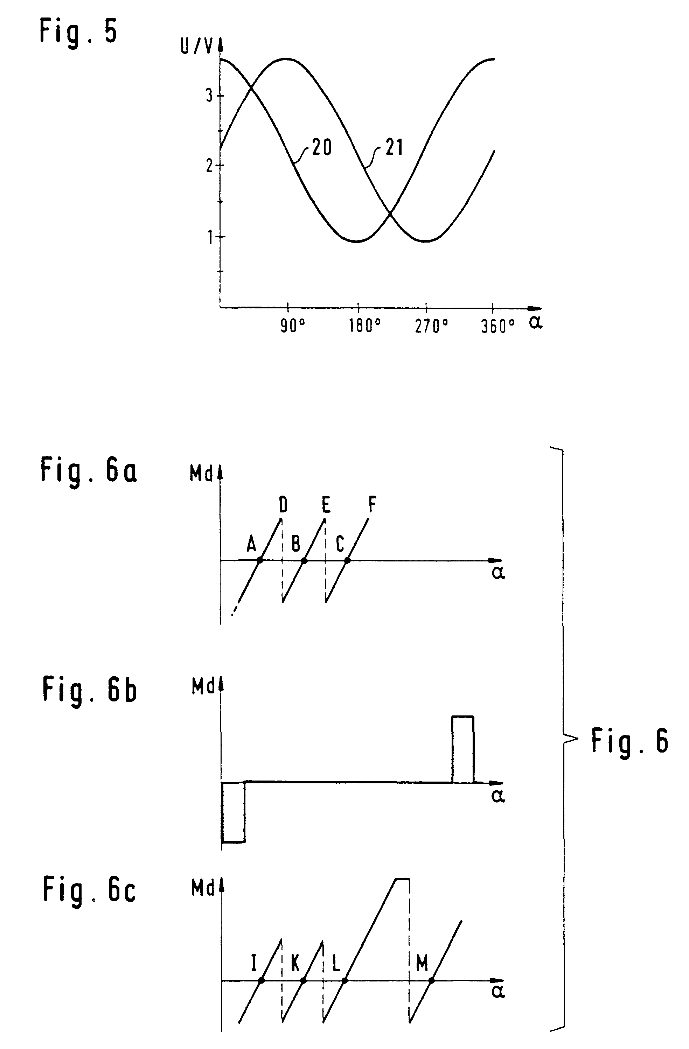

In Figur 5 sind Spannungen 20, 21 dargestellt, die die Hallsensoren 9, 10 in Abhängigkeit der Stellung des Rotors 3 liefern. Man erkennt, daß mit den bei einer Stellung des Rotors 3 gemessenen Spannungen 20, 21 die Stellung des Rotors eindeutig bestimmt werden kann.

In Figur 6 sind mögliche Drehmomentverläufe dargestellt, die mit der erfindungsgemäßen Bedienvorrichtung realisiert werden können.

In Figur 6a ist ein Verlauf des Drehmomentes Md des Motorelements als Funktion des Drehwinkels α dargestellt, der Rastpunkte A, B, C nachbildet. Wird von diesen Rastpunkten ausgehend der Winkel α manuell vergrößert, so wird ein positives Drehmoment Md erzeugt, das entgegengesetzt zur Betätigungskraft gerichtet und bestrebt ist, den Winkel α zu verkleinern. Überwindet der Bediener durch entsprechenden Kraftaufwand einen der Punkte D, E, so kehrt das im Motorelement erzeugte Drehmoment Md seine Richtung um, so daß der Drehknopf auch ohne äußeren Kraftaufwand auf den folgenden Rastpunkt B, C bewegt wird, also einrastet. Entsprechendes gilt für die manuelle Bewegung in entgegengesetzter Richtung. Ein derartiger Drehmomentverlauf kann z.B. erzeugt werden, wenn mit der Bedienvorrichtung die Lautstärkeregelung eines Audiogerätes vorgenommen werden soll.

In Figur 6b ist ein Drehmomentverlauf dargestellt, der federnde Anschläge an den Enden des Einstellbereichs nachbildet. Ein derartiger Drehmomentverlauf ist z.B. vorteilhaft einsetzbar, wenn mit der Bedienvorrichtung die Frequenz eines Rundfunkempfängers eingestellt werden soll.

In Figur 6c sind ebenfalls Rastpunkte I, K, L, M nachgebildet. Hierbei ist im Unterschied zu Figur 6a der Rastpunkt M vom Rastpunkt L nur erreichbar, wenn eine besonders große manuelle Kraft aufgewendet wird, um das hohe Drehmoment zu überwinden. Ein solcher Verlauf ist vorteilhafterweise dann einsetzbar, wenn mit der Bedienvorrichtung verschiedene Menü-Punkte auswählbar sein sollen und der Menü-Punkt, der der Raststellung M entspricht, nur in bestimmten Fällen ausgewählt werden soll und der Bediener durch die hohe aufzuwendende Kraft darauf hingewiesen werden soll.

Die Drehmomentkurve kann auch so ausgestaltet werden, daß das Motorelement beim Überschreiten eines bestimmten Winkels α den Drehknopf mit einer konstanten oder variablen Geschwindigkeit weiterdreht. Weiterhin kann das Motorelement den Drehknopf zwischen zwei Winkeln hin- und herbewegen, so daß sich für den Benutzer ein Rüttelempfinden ergibt.

## Patentansprüche

1. Bedienvorrichtung zur manuellen Eingabe von Informationen in ein Gerät, mit einem Stellglied (1), dessen Stellung unter Einwirkung einer Betätigungskraft veränderbar ist und das mit einem Wandler (3, 9, 10) zur Erzeugung von elektrischen Signalen verbunden ist, die die Stellung des Stellgliedes kennzeichnen und mit einem mit dem Stellglied verbundenen Motorelement (2, 3, 4 5), das unter Steuerung der elektrischen Signale eine Kraft auf das Stellglied ausübt, deren Größe und Richtung von der Stellung des Stellgliedes (1) und/oder von der einzugebenden Information abhängig ist, **dadurch gekennzeichnet, daß** der Wandler aus dem Rotor (3) des Motorelementes und Sensoren (9, 10) besteht, die in Abhängigkeit der Stellung des Rotors jeweils ein elektrisches Signal abgeben.

2. Bedienvorrichtung nach Anspruch 1, **dadurch gekennzeichnet, daß** der Rotor (3) aus einer diametral magnetisierten Scheibe besteht.

3. Bedienvorrichtung nach Anspruch 1 oder 2, **dadurch gekennzeichnet, daß** die Sensoren (9, 10) Hallsensoren sind.

4. Bedienvorrichtung nach Anspruch 3, **dadurch gekennzeichnet, daß** zwei Hallsensoren (9, 10) vorhanden sind.

5. Bedienvorrichtung nach Anspruch 4, **dadurch gekennzeichnet, daß** die Hallsensoren (9, 10) im gleichen radialen Abstand um 90° in Drehrichtung versetzt angeordnet sind.

6. Bedienvorrichtung nach Anspruch 1 oder 2, **dadurch gekennzeichnet, daß** die Sensoren aus Reedkontakten bestehen.

7. Bedienvorrichtung nach einem der vorstehenden Ansprüche, **dadurch gekennzeichnet, daß** das Motorelement ein Kreuzspulenpaar (4, 5) aufweist.

8. Bedienvorrichtung nach Anspruch 7, **dadurch gekennzeichnet, daß** eine Vorrichtung zum Bestromen des Kreuzspulenpaars (4, 5) zum Erzeugen von vorgegebenen Momentenkennlinien vorhanden ist, bei der eine Speichereinrichtung zum Speichern der Momentenkennlinie vorhanden ist.

9. Bedienvorrichtung nach Anspruch 8, **dadurch gekennzeichnet, daß** die Momentenkennlinien aus dem Speicher auslesbar sind.

10. Vorrichtung nach einem der Ansprüche 7 - 9, **dadurch gekennzeichnet, daß** die Spulen (4, 5) auf einen Wickelkörper (6, 7) gewickelt sind.

11. Bedienvorrichtung nach Anspruch 10, **dadurch gekennzeichnet, daß** der Wickelkörper (6, 7) den Rotor (3) vollständig einschließt.

12. Bedienvorrichtung nach einem der vorstehenden Ansprüche, **dadurch gekennzeichnet, daß** zwischen dem Stellglied (1) und dem Motorelement (3, 4, 5) ein Getriebe (15, 16) vorhanden ist.

13. Bedienvorrichtung nach einem der vorstehenden Ansprüche, **dadurch gekennzeichnet, daß** das Stellglied (1) als Stellknopf ausgebildet ist.

14. Bedienvorrichtung nach einem der vorstehenden Ansprüche, **dadurch gekennzeichnet, daß** die Sensoren (9, 10) auf einer Leiterplatte angeordnet sind, die sich unterhalb der Spule und/oder des Wickelkörpers befindet.

15. Bedienvorrichtung nach einem der vorstehenden Ansprüche, **dadurch gekennzeichnet, daß** sie an ihrer Unterseite und weitgehend an ihren Seiten von einem Rückschlußtopf (13) umschlossen ist.

16. Bedienvorrichtung nach Anspruch 15, **dadurch gekennzeichnet, daß** der Rückschlußtopf (13) aus weichmagnetischem Material mit einer hohen magnetischen Hysterese besteht.

## Claims

1. Control apparatus for manual inputting of information into an appliance, having an actuating element (1) whose position can be varied under the influence of an operating force and who is connected to a transducer (3, 9, 10) for producing electrical signals which identify the position of the actuating element, and having a motor element (2, 3, 4, 5) which is connected to the actuating element and, under the control of the electrical signals, exerts a force on the actuating element whose magnitude and direction are dependent on the position of the actuating element (1) and/or on the information to be input, **characterized in that** the transducer comprises the rotor (3) of the motor element and sensors (9, 10) which each emit an electrical signal as a function of the position of the rotor.

2. Control apparatus according to Claim 1, **characterized in that** the rotor (3) comprises a diametrically magnetized disc.

3. Control apparatus according to Claim 1 or 2, **characterized in that** the sensors (9, 10) are Hall sensors.

4. Control apparatus according to Claim 3, **characterized in that** two Hall sensors (9, 10) are provided.

5. Control apparatus according to Claim 4, **characterized in that** the Hall sensors (9, 10) are arranged offset through 90° in the rotation direction at the same radial distance.

6. Control apparatus according to Claim 1 or 2, **characterized in that** the sensors comprise Reed contacts.

7. Control apparatus according to one of the preceding claims, **characterized in that** the motor element has a cruciform coil pair (4, 5).

8. Control apparatus according to Claim 7, **characterized in that** an apparatus for passing current through the cruciform coil pair (4, 5) is provided in order to produce predetermined torque characteristics, and in which a memory device is provided for storing the torque characteristic.

9. Control apparatus according to Claim 8, **characterized in that** the torque characteristics can be read from the memory.

10. Apparatus according to one of Claims 7 - 9, **characterized in that** the coils (4, 5) are wound on a winding former (6, 7).

11. Control apparatus according to Claim 10, **characterized in that** the winding former (6, 7) completely encloses the rotor (3).

12. Control apparatus according to one of the preceding claims, **characterized in that** a gearbox (15, 16) is provided between the actuating element (1) and the motor element (3, 4, 5).

13. Control apparatus according to one of the preceding claims, **characterized in that** the actuating element (1) is in the form of an actuating knob.

14. Control apparatus according to one of the preceding claims, **characterized in that** the sensors (9, 10) are arranged on a printed circuit board, which is located underneath the coil and/or the winding former.

15. Control apparatus according to one of the preceding claims, **characterized in that** the said control apparatus is surrounded on its lower face and largely on its sides by a magnetic return path pot (13).

16. Control apparatus according to Claim 15, **characterized in that** the magnetic return path pot (13) is composed of soft-magnetic material with high magnetic hysteresis.

## Revendications

1. Dispositif de commande pour l'introduction manuelle d'informations dans un appareil, avec un organe d'actionnement (1) dont la position peut être modifiée sous l'action d'une force d'actionnement et qui est relié à un convertisseur (3, 9, 10) pour la création de signaux électriques qui **caractérisent** la position de l'organe d'actionnement, et avec un élément de moteur (2, 3, 4, 5) relié à l'organe d'actionnement qui, sous la commande des signaux électriques, exerce sur l'organe d'actionnement une force dont la grandeur et la direction dépendent de la position de l'organe d'actionnement (1) et/ou de l'information à introduire, **caractérisé en ce que** le convertisseur est constitué du rotor (3) de l'élément de moteur et des sondes (9, 10) qui délivrent chacune un signal électrique en fonction de la position du rotor.

2. Dispositif de commande selon la revendication 1, **caractérisé en ce que** le rotor (3) est constitué d'un disque aimanté diamétralement.

3. Dispositif de commande selon la revendication 1 ou 2, **caractérisé en ce que** les sondes (9, 10) sont des sondes de Hall.

4. Dispositif de commande selon la revendication 3, **caractérisé en ce que** deux sondes de Hall (9, 10) sont présentes.

5. Dispositif de commande selon la revendication 4, **caractérisé en ce que** les sondes de Hall (9, 10) sont disposées à même distance radiale et décalées de 90° dans le sens de rotation.

6. Dispositif de commande selon la revendication 1 ou 2, **caractérisé en ce que** les sondes sont constituées de contacts à lames souples.

7. Dispositif de commande selon l'une des revendications précédentes, **caractérisé en ce que** l'élément de moteur présente une paire de bobines croisées (4, 5).

8. Dispositif de commande selon la revendication 7, **caractérisé en ce qu'**il existe un dispositif pour l'alimentation en courant de la paire de bobines croisées (4, 5), pour créer des lignes caractéristiques de couple prédéterminées et dans lequel un dispositif à mémoire pour la conservation de la ligne caractéristique de couple est présent.

9. Dispositif de commande selon la revendication 8, **caractérisé en ce que** les lignes caractéristiques de couple peuvent être lues dans la mémoire.

10. Dispositif selon l'une des revendications 7 à 9, **caractérisé en ce que** les bobines (4, 5) sont enroulées sur un corps de bobinage (6, 7).

11. Dispositif de commande selon la revendication 10, **caractérisé en ce que** le corps de bobinage (6, 7) enferme complètement le rotor (3).

12. Dispositif de commande selon l'une des revendications précédentes, **caractérisé en ce qu'**entre l'organe d'actionnement (1) et l'élément de moteur (3, 4, 5), il existe une transmission (15, 16).

13. Dispositif de commande selon l'une des revendications précédentes, **caractérisé en ce que** l'organe d'actionnement (1) présente la forme d'un bouton d'actionnement.

14. Dispositif de commande selon l'une des revendications précédentes, **caractérisé en ce que** les sondes (9, 10) sont disposées sur une carte de circuit imprimé qui se trouve en dessous de la bobine et/ou du corps de bobinage.

15. Dispositif de commande selon l'une des revendications précédentes, **caractérisé en ce qu'**il est enfermé sur son côté inférieur et largement sur ses côtés latéraux par un chapeau de fermeture arrière (13).

16. Dispositif de commande selon la revendication 15, **caractérisé en ce que** le chapeau de fermeture arrière (13) est constitué d'un matériau magnétique doux avec une haute hystérésis magnétique.
